# EUROPEAN PATENT APPLICATION

(11) **EP 4 847 660 A1**
(43) Date of publication of application: **02.12.2026**
(21) Application number: 25759888.8
(22) Date of filing: 26.02.2025
(51) Int. Cl.: C23C 14/34

(54) **SINTERED BODY, SPUTTERING TARGET, AND METHOD FOR PRODUCING SINTERED BODY**

(30) Priority: 26.02.2024 JP 2024026809
(71) Applicant: JX Advanced Metals Corporation, Tokyo 105-8417 (JP)
(72) Inventor: YAMAMOTO, Hiroyoshi, Kitaibaraki-shi, Ibaraki 319-1535 (JP); SUITO, Kosuke, Kitaibaraki-shi, Ibaraki 319-1535 (JP); NARA, Atsushi, Kitaibaraki-shi, Ibaraki 319-1535 (JP)
(74) Representative: Forresters IP LLP
(86) International application number: PCT/JP2025/006541
(87) International publication number: WO 2025/182965

(57) **Abstract**

An object of the present disclosure is to provide a sintered body, a sputtering target, and a method for producing a sintered body containing indium, zinc, and oxygen and having excellent thermal shock resistance. An IZO sintered body containing indium, zinc, and oxygen, comprising an In₂O₃ phase and a Zn₄In₂O₇ phase, wherein when an X-ray diffraction peak intensity of the Zn₄In₂O₇ phase at 34.1° ≤ 2θ ≤ 35.1° is I1, and a sum of X-ray diffraction peak intensities of a Zn₃In₂O₆ phase or a Zn₅In₂O₈ phase at 34.1° ≤ 2θ ≤ 35.1° is I2, I1/I2 is 1.0 or more.

## Description

### [Technical Field]

The present disclosure relates to a sintered body, a sputtering target, and a method for producing a sintered body.

### [Background Art]

Thin films of oxides mainly composed of indium oxide, such as an indium oxide-tin oxide-based oxide (referred to as "ITO") and an indium oxide-zinc oxide-based oxide (referred to as "IZO"), have high electrical conductivity and high transmittance in the visible light region, and thus are used as electrode materials for various flat panel displays. In particular, IZO possesses characteristics such as providing low resistance and high transmittance when formed into a film at room temperature, enabling the formation of a stable amorphous film, having good etching characteristics, and providing high film flatness. In addition, IZO possesses characteristics as an oxide semiconductor, and its use in channel layers of TFTs and the like is also being considered.

As a method for forming an IZO film, a sputtering method using an IZO sputtering target produced from an IZO sintered body is widely used. Regarding IZO sputtering targets, for example, Patent Document 1 discloses a sintered body target which is a composite oxide of In₂O₃ and ZnₖIn₂Oₖ₊₃ (k is any one or more of 3, 4, and 5), wherein a relative density of the target is 98.4% or more, the number of micropores of 50 to 300 nm present in the target is 10 or less, and an atomic ratio of Zn to In, Zn/(In+Zn), is in a range of 0.1 to 0.2.

### [Prior Art Documents]

### [Patent Documents]

[Patent Document 1] Japanese Patent No. 6078189

### [Summary of the Invention]

### [Problems to be Solved by the Invention]

In an IZO sputtering target containing indium, zinc, and oxygen, there is a problem in that fractures and cracks occur in the sputtering target due to thermal shock during sputtering. In view of the above problem, an object of the present disclosure is to provide a sintered body and a sputtering target that contain indium, zinc, and oxygen and have excellent thermal shock resistance, as well as a method for producing the sintered body.

### [Means for Solving the Problems]

The gist of the present disclosure is as follows.
[1] An IZO sintered body comprising indium, zinc, and oxygen, wherein the sintered body comprises an In₂O₃ phase and a Zn₄In₂O₇ phase, and when an X-ray diffraction peak intensity of the Zn₄In₂O₇ phase at 34.1° ≤ 2θ ≤ 35.1° is I1, and a sum of X-ray diffraction peak intensities of a Zn₃In₂O₆ phase and a Zn₅In₂O₈ phase at 34.1° ≤ 2θ ≤ 35.1° is I2, I1/I2 is 1.0 or more.
[2] The sintered body according to [1], wherein an average crystal grain size is 2 µm or less.
[3] The sintered body according to [1] or [2], wherein a relative density is 90% or more and less than 99%.
[4] The sintered body according to any one of [1] to [3], wherein a rate of decrease in transverse rupture strength calculated from the following formula is 40% or less: 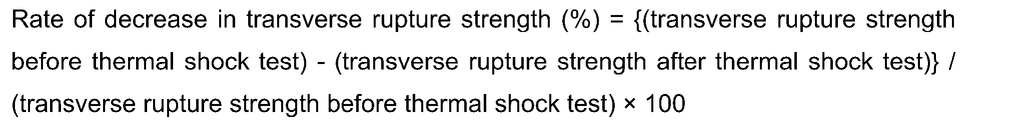 Rate of decrease in transverse rupture strength (%) = {(transverse rupture strength before thermal shock test) - (transverse rupture strength after thermal shock test)} / (transverse rupture strength before thermal shock test) × 100 where the thermal shock test is performed by heating the sintered body in the air under conditions of a heating rate of 5°C/min, a holding temperature of 200°C, and a holding time of 30 minutes, and then rapidly cooling the sintered body immediately after heating by allowing it to fall naturally from a height of 30 cm above a water surface into a water tank (water temperature: 20°C ± 3°C) with a depth of 30 cm.
[5] The sintered body according to any one of [1] to [4], wherein a volume resistivity is 10 mΩ·cm or less.
[6] The sintered body according to any one of [1] to [5], wherein a Zn content is 1% by mass or more and 37% by mass or less in terms of ZnO.
[7] A sputtering target comprising the sintered body according to any one of [1] to [6].
[8] A method for producing a sintered body, comprising: mixing an In₂O₃ powder and a ZnO powder to obtain a mixed powder; calcining the obtained mixed powder at 1200°C or higher and lower than 1258°C; and then pressure-sintering the calcined powder under conditions of a temperature of 1100°C or higher and 1250°C or lower and a pressing pressure of 150 kgf/cm² or more in a vacuum or an inert gas atmosphere.

### [Effect of the Invention]

According to the present disclosure, it is possible to provide a sintered body and a sputtering target that contain indium, zinc, and oxygen and have excellent thermal shock resistance, as well as a method for producing the sintered body.

### [Brief Description of Drawings]

[FIG. 1] FIG. 1 is an X-ray diffraction pattern (10° ≤ 2θ ≤ 80°) of a sintered body of Example 2.
[FIG. 2] FIG. 2 is an X-ray diffraction pattern (34.1° ≤ 2θ ≤ 35.1°) of the sintered body of Example 2.

### [Mode for Carrying Out the Invention]

Hereinafter, the present disclosure will be described with reference to specific embodiments. However, each configuration and combinations thereof in each embodiment are merely examples, and additions, omissions, substitutions, and other modifications can be made as appropriate without departing from the gist of the present disclosure.

A sintered body according to an embodiment of the present disclosure (hereinafter referred to as the "present embodiment") contains indium, zinc, and oxygen. A sintered body having such a composition is referred to as an IZO sintered body. Note that IZO is an abbreviation taken from the initial letters of the respective constituent elements: indium (In), zinc (Zn), and oxygen (O). IZO thin films can be utilized as transparent conductive films and oxide semiconductors.

An IZO thin film can usually be formed using a sputtering method. A thin film having substantially the same composition as the sputtering target can be formed by placing a sputtering target produced from an IZO sintered body (referred to as an IZO sputtering target) in a vacuum chamber, causing argon ions generated by glow discharge to collide with the sputtering target at high speed, and depositing the ejected atoms or the like on an opposing glass substrate or the like.

The sintered body according to the present embodiment comprises an In₂O₃ phase and a Zn₄In₂O₇ phase, wherein when an X-ray diffraction peak intensity of the Zn₄In₂O₇ phase at 34.1° ≤ 2θ ≤ 35.1° is I1, and a sum of X-ray diffraction peak intensities of a Zn₃In₂O₆ phase and a Zn₅In₂O₈ phase at 34.1° ≤ 2θ ≤ 35.1° is I2, I1/I2 is 1.0 or more. If I1/I2 is 1.0 or more, it can be determined that the Zn₄In₂O₇ phase is the main phase among the composite oxide phases of indium and zinc. A composite oxide of indium and zinc includes a Zn₃In₂O₆ phase, a Zn₅In₂O₈ phase, and the like in addition to the Zn₄In₂O₇ phase. By making the Zn₄In₂O₇ phase the main phase among these composite oxide phases, the thermal shock resistance of the IZO sputtering target can be improved. A sputtering target having excellent thermal shock resistance can suppress cracks and fractures during sputtering.

The sintered body according to the present embodiment preferably has an average crystal grain size of 2 µm or less. The average crystal grain size is more preferably 1.5 µm or less, and further preferably 1 µm or less. If the average crystal grain size of the sintered body is coarse, the transverse rupture strength decreases, and cracks or fractures may occur during sputtering. Cracks and fractures cause the generation of particles and nodules during sputtering. Therefore, in order to prevent cracks and fractures, it is preferable to refine the structure of the IZO sintered body (IZO sputtering target). Note that since the crystal grain size depends on the particle size of the powder used as the sintering raw material and various sintering conditions, these need to be appropriately controlled.

Since a fine crystal structure is required for an IZO sintered body, sintering at a low temperature capable of suppressing grain growth is preferable. On the other hand, it is difficult to obtain a high-density sintered body via low-temperature sintering. However, according to the production method of the present disclosure described later, it is possible to obtain a high-density sintered body while suppressing grain growth. A sputtering target composed of a high-density IZO sintered body can suppress the generation of particles during sputtering. If the relative density is too low, the transverse rupture strength of the sintered body decreases, making it unsuitable as a sintered body for producing a sputtering target. On the other hand, if the relative density of the sintered body is too high, sudden thermal stress is easily transmitted, and the rate of decrease in transverse rupture strength due to heat treatment increases. Therefore, the sintered body according to the present embodiment preferably has a relative density of 90% or more and less than 99%. The relative density is more preferably 92% or more, particularly preferably 95% or more, and the relative density is more preferably 98% or less, particularly preferably 97% or less.

In the present disclosure, thermal shock resistance is evaluated from the rate of decrease in transverse rupture strength of the sintered body before and after a thermal shock test. It can be determined that the lower the rate of decrease in transverse rupture strength after the thermal shock test, the more excellent the thermal shock resistance.

The rate of decrease in transverse rupture strength is calculated according to the following procedure.
(1) The transverse rupture strength of the sintered body before the thermal shock test is measured.
(2) The sintered body is heated in the air under conditions of a heating rate of 5°C/min, a holding temperature of 200°C, and a holding time of 30 minutes.
(3) The sintered body immediately after heating is rapidly cooled by allowing it to fall naturally from a height of 30 cm above a water surface into a water tank (water temperature: 20°C ± 3°C) with a depth of 30 cm.
(4) The transverse rupture strength of the sintered body after the thermal shock test according to (2) and (3) is measured.
(5) From the transverse rupture strengths measured in (1) and (4), the rate of decrease in transverse rupture strength is calculated using the following formula. 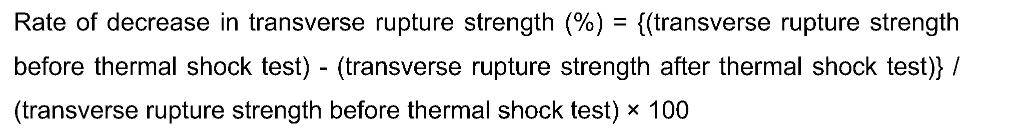 Rate of decrease in transverse rupture strength (%) = {(transverse rupture strength before thermal shock test) - (transverse rupture strength after thermal shock test)} / (transverse rupture strength before thermal shock test) × 100

Note that the rate of decrease in transverse rupture strength varies greatly depending on the composition of the sintered body. That is, as the Zn content increases (as the In content decreases), the rate of decrease in transverse rupture strength tends to decrease.

The sintered body according to the present embodiment preferably has a volume resistivity of 10 mΩ·cm or less. If the volume resistivity is high, arcing occurs during sputtering, which causes particles. Therefore, the volume resistivity is preferably as low as possible. When oxygen vacancies are generated in the sintered body, the volume resistivity decreases. Therefore, the sintering conditions are adjusted so as to generate oxygen vacancies. The volume resistivity is preferably 6 mΩ·cm or less, and more preferably 3 mΩ·cm or less.

The sintered body according to the present embodiment contains indium (In), zinc (Zn), and oxygen (O), and the contents thereof are not particularly limited. However, since the Zn content affects the electrical conductivity of the target film, the Zn content is preferably 1% by mass or more and 37% by mass or less in terms of ZnO. The lower limit of the Zn content is more preferably 2.5% by mass or more, and particularly preferably 7.0% by mass or more, in terms of ZnO. In addition, the upper limit of the Zn content is preferably 25% by mass or less, and particularly preferably 15% by mass or less, in terms of ZnO.

The sintered body of the present embodiment can be used as a material for PVD (Physical Vapor Deposition), and can be used as, for example, a sputtering target, a vacuum deposition material, an ion plating material, and the like. When used as a sputtering target, it can be in the shape of a flat disk, a rectangular flat plate, or a cylinder, and can be joined to a backing plate using a bonding material. In addition, when used as a sputtering target, its thickness can be 20 mm or less, preferably 3.0 to 15 mm, and more preferably 3.0 to 12 mm. The area of the surface to be sputtered (sputtering surface) is preferably 44 cm² or more, or the diameter is preferably 75 mm or more.

A method for producing the sintered body and the sputtering target according to the present embodiment will be described. However, it is obvious that the following production conditions and the like are not limited to the disclosed ranges, and some omissions and modifications may be made. Note that in order to avoid the disclosed production method from being unnecessarily unclear, detailed descriptions of well-known production steps and processing operations are omitted.

### (1. Raw Material Powders)

An indium oxide (In₂O₃) powder and a zinc oxide (ZnO) powder are prepared as raw material powders. The In₂O₃ powder preferably has a median diameter d50 of 0.5 to 3.0 µm and a specific surface area of 4.0 to 10 m²/g. The ZnO powder preferably has a median diameter d50 of 0.1 to 2.0 µm. Furthermore, it is preferable to use raw material powders having a purity of 99.9% by mass or more.

### (2. Mixing Step)

The above raw material powders are weighed so as to achieve a desired composition ratio (content ratio of the sintered body), and then mixed and pulverized. There are various pulverization methods depending on the desired particle size and the substance to be pulverized, but a wet or dry ball mill, a vibration mill, a bead mill, or the like can be used. In order to obtain uniform and fine crystal grains, a wet bead mill mixing method is preferable because the crushing efficiency of agglomerates in a short time is high and the dispersion state of additives is also favorable. The median diameter d50 after pulverization is preferably 0.1 to 1.0 µm.

### (3. Sieving Step)

The slurry pulverized above is dried, and in order to break up agglomeration during drying, sieving may be further performed using a sieve. The agglomeration can be broken up if the sieve opening is 500 µm or less. The smaller the opening, the more the agglomeration can be broken up. By setting the opening to 250 µm, and further to 150 µm, the agglomeration can be broken up even more. On the other hand, if the opening is too small, the operation may become cumbersome.

### (4. Calcining Step)

Next, the mixed powder is calcined at 1200°C or higher and lower than 1258°C. By performing calcination, a Zn₄In₂O₇ phase is generated prior to sintering. If the calcination temperature is 1258°C or higher, a Zn₃In₂O₆ phase is generated in the sintered body instead of the target Zn₄In₂O₇ phase. Moreover, if the calcination temperature is too high, excessive hardening occurs, and crushing in a subsequent step may become cumbersome. On the other hand, if the temperature is lower than 1200°C, the target Zn₄In₂O₇ phase and an untargeted Zn₅In₂O₈ phase are formed. The calcination time is preferably 1 hour or more and 10 hours or less. If the calcination time is too short, the target crystal phase is not formed. On the other hand, if the calcination time is too long, firing shrinkage becomes strong, and crushing in a subsequent step may become cumbersome. The heating rate and the cooling rate are not particularly limited. For example, the temperature can be raised to the target temperature at 1°C/min or more and 10°C/min or less, and after the temperature holding is completed, the temperature can be lowered by furnace cooling.

### (5. Crushing Step: Optional)

The calcined powder obtained by the above calcination is preferably crushed with a sieve. The hardened agglomerates can be broken up if the sieve opening is 500 µm or less. The smaller the opening, the more the agglomerates can be broken up. By setting the opening to 250 µm, and further to 150 µm, the firing shrinkage can be broken up even more. On the other hand, if the opening is too large, the pulverizing operation in the next step may become cumbersome.

### (6. Pulverizing Step: Optional)

Next, pulverization can be performed as necessary. There are various pulverization methods depending on the desired particle size and the substance to be pulverized, but a wet or dry ball mill, a vibration mill, a bead mill, or the like can be used. In order to obtain uniform and fine crystal grains, a wet bead mill mixing method is preferable because the crushing efficiency of agglomerates in a short time is high and the dispersion state of additives is also favorable. The median diameter d50 after pulverization is preferably 0.1 to 1.0 µm.

### (7. Sintering Step)

Next, the calcined powder is sintered. Conventionally, sintering has been performed in the air or in an oxygen gas atmosphere at about 1400°C to 1600°C. However, when the sintering temperature is high, there is a problem that grain growth occurs and the transverse rupture strength decreases. In addition, the volume resistivity becomes high, particles are generated during sputtering, and stable sputtering has been difficult. In particular, stabilization of sputtering is important when the sputtering target is enlarged and when attempting to uniformly form a film by high-power sputtering.

### (7-1. Sintering Method)

In the production method of the present disclosure, pressure sintering is performed from the viewpoint of increasing the relative density at a relatively low temperature. As the pressure sintering, hot press (HP) sintering or SPS (Spark Plasma Sintering) can be used. The atmosphere during sintering can be a vacuum or an inert gas atmosphere, but it is preferable to perform sintering in an inert gas atmosphere rather than a vacuum. Furthermore, if sintering is performed without applying pressure (normal pressure) in an inert gas atmosphere, In₂O₃ is reduced, which inhibits the improvement in the density of the sintered body, and may contaminate the inside of the apparatus. Therefore, pressure sintering is preferable also from the viewpoint of suppressing reduction to some extent, and hot press sintering is particularly preferable from the viewpoint of productivity. The sintering temperature is preferably 1100°C or higher and 1250°C or lower. If the temperature is lower than 1100°C, the density of the sintered body is not sufficiently increased. On the other hand, if the temperature exceeds 1250°C, there is a problem that the Zn₃In₂O₆ phase is generated in the sintered body instead of the target Zn₄In₂O₇ phase.

### (7-2. Pressing Pressure)

The pressing pressure in the pressure sintering is preferably 150 kgf/cm² or more. If the pressing pressure is less than 150 kgf/cm², the density of the sintered body may decrease. Although there is no particular restriction on the upper limit, the pressing pressure is preferably 500 kgf/cm² or less from the perspective of the strength of members used for pressure sintering.

### (7-3. Sintering Holding Time)

The holding time at the maximum sintering temperature is preferably 3 hours or more and 10 hours or less. A shorter holding time is preferable since productivity is improved, but if the holding time is short, it is difficult to obtain a high-density sintered body. In the production method of the present disclosure, since relatively high-temperature sintering is possible as described above, the holding time can be shortened accordingly, and productivity can be significantly improved.

### (7-4. HIP Treatment: Optional)

After the pressure sintering, the obtained sintered body may be subjected to HIP (Hot Isostatic Pressing) treatment. The HIP treatment is preferably performed at 900°C or higher and 1250°C or lower. Moreover, the applied pressure is preferably 1000 kgf/cm² or more and 1800 kgf/cm² or less, and the treatment time is preferably 1 hour or more and 10 hours or less.

### (8. Finishing Process)

The sintered body obtained through the above sintering step can be processed into a desired shape by a processing machine such as a surface grinder, a cylindrical grinder, or a machining center, as necessary, and the surface can be polished to form a sputtering target. The shape of the sputtering target is not particularly limited, and can be a flat disk shape, a rectangular shape, a cylindrical shape, or the like. In addition, the sputtering target can be joined to a backing plate as necessary and used.

### [Examples]

Hereinafter, description will be given based on Examples and Comparative Examples. However, these Examples are merely examples, and are not limited in any way by this example. That is, the present invention is limited only by the scope of claims, and encompasses various modifications other than the Examples included in the present disclosure.

Evaluation methods used in Examples and Comparative Examples were as follows. Since a sputtering target is produced by subjecting a sintered body to processing such as grinding and polishing, the characteristics of the sintered body can be equated with the characteristics of the sputtering target. Furthermore, in the present disclosure, various evaluations are performed on a sample representative of the sintered body. When various physical properties of a representative sample are included in the scope of the present disclosure, the sintered body is encompassed by the present invention. That is, measuring a specific, exceptional, or partial sample that does not represent the sintered body and taking it as departing from the scope of the present disclosure does not exclude it from the scope of the present disclosure.

### (Composition Analysis)

The composition of the sintered body was analyzed using the following apparatus.
Apparatus: SPS3500DD manufactured by SII
Method: ICP-OES (Inductively Coupled Plasma Optical Emission Spectrometry)

### (Analysis of Crystal Phase)

A sample (15 mm × 15 mm × 10 mm) was cut out from the sintered body, and a surface of the cut-out sample (a surface corresponding to the sputtering surface) was mirror-polished using a slurry abrasive (COMPOL 120 manufactured by Fujimi Incorporated). Then, the crystal phase of the sintered body was analyzed using the following apparatus.
Principle: X-ray diffraction method
Apparatus: Ultima IV manufactured by Rigaku Corporation
X-ray tube: Cu-Kα ray
Tube voltage: 40 kV
Current: 30 mA
Measurement method: 2θ-θ reflection method
Scan speed: 40°/min
Sampling interval: 0.01°
Measurement range (2θ): 10° to 120°
Divergence slit: 1°
Divergence length limiting slit: 10 mm
Scattering slit: 8 mm
Receiving slit: Open state
Goniometer: Horizontal sample type
Sample measurement location: Sputtering cross-section side

Assuming that an X-ray diffraction peak intensity in 34.1° ≤ 2θ ≤ 35.1° assigned to the Zn₄In₂O₇ phase is I1, and a sum of X-ray diffraction peak intensities at 34.1° ≤ 2θ ≤ 35.1° of the Zn₃In₂O₆ phase and the Zn₅In₂O₈ phase is I2, I1/I2 was calculated.

As for the X-ray diffraction peak intensity of each crystal phase, since the X-ray diffraction peak may shift during the measurement, the X-ray diffraction peak intensity assigned to the Zn₅In₂O₈ phase (ICDD card number, 01-089-8974) was defined as the maximum peak intensity at 34.74° ± 0.05°.

Also, the X-ray diffraction peak intensity of the Zn₃In₂O₆ phase (ICDD card number, 00-020-1439) was defined as the maximum peak intensity at 34.23° ± 0.05°.

Also, the X-ray diffraction peak intensity of the Zn₄In₂O₇ phase (ICDD card number, 01-077-8496) was defined as the maximum peak intensity at 34.97° ± 0.05°.

### (Relative Density)

The relative density was calculated using the following formula. $Relative density \left(%\right) = Archimedes density / Calculated density \times 100$

Archimedes density: Upper and lower surfaces and an outer peripheral surface of the sintered body were ground so as to remove an altered layer to prepare a sample (15 mm × 15 mm × 10 mm), and the Archimedes density was calculated using the Archimedes method. Note that when the relative density is 94% or less, it is preferable to calculate it by dimensional density.

Calculated density: A component analysis of the sintered body was performed, and a calculated density was obtained using the oxide mass ratio (mass %) converted from the respective atomic ratios (at%) of In and Zn relative to a total 100 at% of the constituent elements In and Zn, and the following theoretical densities of In₂O₃ and ZnO. $Calculated density \left(g/{cm}^{3}\right) = \left(W1+W2\right) / \left(W1/d1+W2/d2\right)$
W1: Mass ratio of In₂O₃ (mass %)
W2: Mass ratio of ZnO (mass %)
Theoretical density:
   d1: 7.18 g/cm³ (theoretical density of In₂O₃)
   d2: 5.61 g/cm³ (theoretical density of ZnO)

### (Average Crystal Grain Size)

A sample (15 mm × 15 mm × 10 mm) was cut out from the sintered body, the surface of the cut-out sample was polished, and a structural photograph of the mirror-polished sample surface (a cross section perpendicular to the surface corresponding to the sputtering surface) was taken across 6 fields of view at a magnification of 5000 times using a scanning electron microscope (SEM). Next, on the captured image, three straight lines (referred to as straight lines 1, 2, and 3, respectively) were drawn such that the number of crystal grains crossed by each straight line was 10 or more, and the length of each straight line and the number of crystal grains crossed by each straight line were obtained. At this time, if the end of a straight line terminated inside a crystal grain, that grain was counted as 0.5.

Based on the measured lengths of the straight lines and the number of crystal grains crossed by each straight line, the crystal grain size in one field of view was calculated by the following formula. Crystal grain size in 1 field of view = (Length of straight line 1 / Number of crystal grains crossed by straight line 1 + Length of straight line 2 / Number of crystal grains crossed by straight line 2 + Length of straight line 3 / Number of crystal grains crossed by straight line 3) ÷ 3

Then, for each of the 6 fields of view, the crystal grain size was obtained from the above formula, and the arithmetic average value of the 6 fields of view was defined as the average crystal grain size. However, if the number of crystal grains crossed by each straight line in the field of view is not 10 or more, a magnification of 2000 times or 1000 times may be used. Note that the apparatus used and the measurement conditions were as follows.
Apparatus used: JXA-8500F (manufactured by JEOL Ltd.)
Acceleration voltage: 15.0 kV
Beam current: 5.0 × 10⁻⁸ A

### (Volume Resistivity)

The surface of the sintered body was polished, the volume resistivity was measured at arbitrary five points spaced apart by 1.5 cm or more on the polished surface, and an arithmetic average value and standard deviation of the five points were calculated. The following apparatus was used for the measurement.
Apparatus: Resistivity measuring instrument Σ-5+ manufactured by NPS
System: Constant current application method
Method: DC 4-probe method
Measurement temperature: Room temperature (20 to 25°C)

### (Transverse Rupture Strength)

A sample (40 mm × 4 mm × 3 mm) was cut out from the sintered body, the surface of the cut-out sample was polished with an abrasive (grit #400), and the transverse rupture strength of the polished surface was measured in accordance with JIS R 1601:2008.
Test method: Testing method for flexural strength of fine ceramics at room temperature
Apparatus: Tensile/compression testing machine (Model SV-201NA-50SL)
Test type: 3-point bending strength measurement
Test temperature: 5 to 35°C
Distance between external supporting points: 30 mm
Crosshead speed: 0.5 mm/min
Load range: Range A 500 N

The number of tests was set to 10 or more, and the average value thereof was determined.

### (Example 1)

An In₂O₃ powder and a ZnO powder were prepared, weighed and mixed so as to have the composition shown in Table 1, then calcined at 1210°C, and then pulverized by a wet bead mill so that the median diameter d50 became 0.68 µm. After pulverization, the obtained powder was filled into a carbon die, and hot press (HP) sintering was performed in an argon atmosphere under conditions of a maximum sintering temperature of 1150°C, a pressing pressure of 300 kgf/cm², and a holding time of 3 hours to prepare a sintered body (diameter 210 mm). As a result of measuring physical properties of the sintered body obtained in Example 1, the Zn content in terms of ZnO was 10.7 wt%, and the main crystal phases were an In₂O₃ phase and a Zn₄In₂O₇ phase. The X-ray diffraction peak intensity ratio I1/I2 was 1.29, and the Zn₄In₂O₇ phase was the main phase. Moreover, the transverse rupture strength was 210 MPa, the average crystal grain size was 1.07 µm, the relative density was 98.7%, and the volume resistivity was 0.66 mΩ·cm. Next, regarding the sintered body, the transverse rupture strength after the above-described thermal shock test was measured. As a result, the transverse rupture strength after the heat treatment was 144 MPa, and the rate of decrease in the transverse rupture strength was 31%, indicating good thermal shock resistance.

**[Table 1]**

| | | | Example 1 | Example 2 | Comparative Example 1 | Comparative Example 2 |
|---|---|---|---|---|---|---|
| Sintering conditions | Sintering method | | HP | HP | HP | HP |
| | Calcination temperature | ° C | 1210 | 1210 | 1100 | 1100 |
| | Sintering temperature | ° C | 1150 | 1150 | 1150 | 1150 |
| Sintered body characteristi cs | Zn content | wt% | 10.7 | 37 | 10.7 | 37 |
| | Main crystal phases | | In₂O₃, Zn₄In₂O₇ | In₂O₃, Zn₄In₂O₇ | In₂O₃, Zn₃In₂O₈ | In₂O₃, Zn₅In₂O₈ |
| | X-ray diffraction peak intensity ratio (I1/I2) | | 1.29 | 1.93 | 0.73 | 0.68 |
| | Sintered body dimensions (diameter) | mm | 210 | 160 | 210 | 160 |
| | Average crystal grain size | *µ* m | 1.07 | 1.17 | 0.77 | 0.92 |
| | Relative density | % | 98.7 | 97.7 | 100 | 99.0 |
| | Volume resistivity | mΩ·cm | 0.66 | 0.86 | 1.01 | 1.17 |
| | Transverse rupture strength (before thermal shock test) | MPa | 210 | 192 | 223 | 185 |
| | Transverse rupture strength (after thermal shock test) | MPa | 144 | 165 | 106 | 101 |
| | Rate of decrease in transverse rupture strength | % | 31 | 14 | 52 | 45 |

### (Example 2)

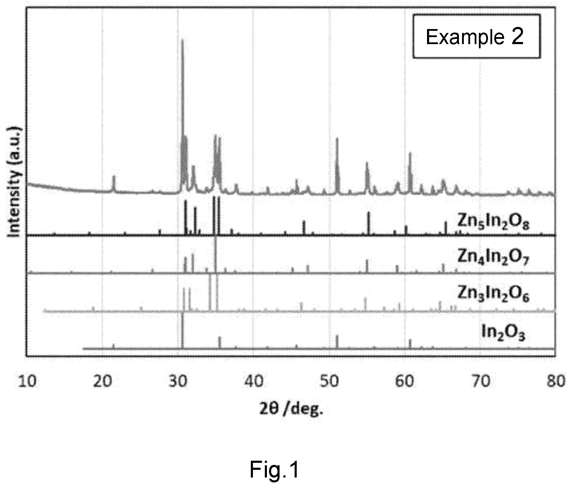

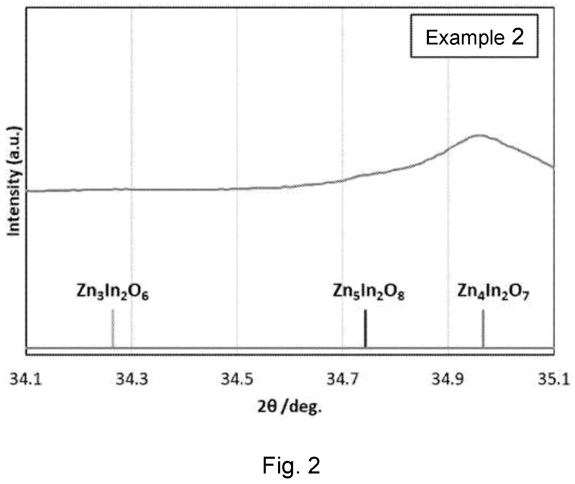

In Example 2, the composition of the sintered body was adjusted so as to be different from that of Example 1, and hot press (HP) sintering was performed in an argon atmosphere under conditions of a maximum sintering temperature of 1150°C, a pressing pressure of 250 kgf/cm², and a holding time of 3 hours to prepare a sintered body (diameter 160 mm). As a result of measuring physical properties of the sintered body obtained in Example 2, the Zn content in terms of ZnO was 37 wt%, and the main crystal phases were an In₂O₃ phase and a Zn₄In₂O₇ phase. The X-ray diffraction peak intensity ratio I1/I2 was 1.93, and the Zn₄In₂O₇ phase was the main phase. For reference, the X-ray diffraction patterns of Example 2 are shown in FIGS. 1 and 2. Moreover, the transverse rupture strength was 192 MPa, the average crystal grain size was 1.17 µm, the relative density was 97.7%, and the volume resistivity was 0.86 mΩ·cm. Next, a thermal shock test was performed on the sintered body, and the transverse rupture strength after the thermal shock test was measured. As a result, the transverse rupture strength after the thermal shock test was 165 MPa, and the rate of decrease in the transverse rupture strength was 14%, indicating good thermal shock resistance.

### (Comparative Example 1)

In Comparative Example 1, the calcination temperature was adjusted to 1100°C, and hot press (HP) sintering was performed in an argon atmosphere under conditions of a maximum sintering temperature of 1150°C, a pressing pressure of 300 kgf/cm², and a holding time of 6 hours to prepare a sintered body (diameter 210 mm). As a result of measuring physical properties of the sintered body obtained in Comparative Example 1, the Zn content in terms of ZnO was 37 wt%, and the main crystal phases were an In₂O₃ phase and a Zn₅In₂O₈ phase. The X-ray diffraction peak intensity ratio I1/I2 was 0.73, and the Zn₅In₂O₈ phase was the main phase. Moreover, the transverse rupture strength was 223 MPa. Next, a thermal shock test was performed on the sintered body, and the transverse rupture strength after the thermal shock test was measured. As a result, the transverse rupture strength after the thermal shock test was 106 MPa, and the rate of decrease in the transverse rupture strength was 52%, indicating inferior thermal shock resistance.

### (Comparative Example 2)

In Comparative Example 2, the calcination temperature was adjusted to 1100°C, and hot press (HP) sintering was performed in an argon atmosphere under conditions of a maximum sintering temperature of 1200°C, a pressing pressure of 250 kgf/cm², and a holding time of 3 hours to prepare a sintered body (diameter 160 mm). As a result of measuring physical properties of the sintered body obtained in Comparative Example 1, the Zn content in terms of ZnO was 37 wt%, and the main crystal phases were an In₂O₃ phase and a Zn₅In₂O₈ phase. The X-ray diffraction peak intensity ratio I1/I2 was 0.68, and the Zn₅In₂O₈ phase was the main phase. Moreover, the transverse rupture strength was 185 MPa. Next, a thermal shock test was performed on the sintered body, and the transverse rupture strength after the thermal shock test was measured. As a result, the transverse rupture strength after the thermal shock test was 101 MPa, and the rate of decrease in the transverse rupture strength was 45%, indicating inferior thermal shock resistance.

According to the present disclosure, since it can be expected to suppress cracks and fractures in the sputtering target, there is a possibility that the product yield can be improved. The improvement in product yield leads to a stable supply of products and a reduction in the loss of metal raw materials, which are limited resources. Therefore, the present disclosure may contribute to Goal 9 "Build resilient infrastructure, promote inclusive and sustainable industrialization and foster innovation" and Goal 12 "Ensure sustainable consumption and production patterns" of the Sustainable Development Goals (SDGs) led by the United Nations.

### [Industrial Applicability]

According to the present disclosure, it is possible to provide an IZO sintered body and an IZO sputtering target containing indium, zinc, and oxygen and having excellent thermal shock resistance. The sintered body and the sputtering target according to the present disclosure are useful for forming an IZO thin film as a transparent conductive film or an oxide semiconductor film.

## Claims

1. An IZO sintered body comprising indium, zinc, and oxygen, wherein the sintered body comprises an In₂O₃ phase and a Zn₄In₂O₇ phase, and when an X-ray diffraction peak intensity of the Zn₄In₂O₇ phase at 34.1° ≤ 2θ ≤ 35.1° is I1, and a sum of X-ray diffraction peak intensities of a Zn₃In₂O₆ phase or a Zn₅In₂O₈ phase at 34.1° ≤ 2θ ≤ 35.1° is I2, I1/I2 is 1.0 or more.

2. The sintered body according to claim 1, wherein an average crystal grain size is 2 µm or less.

3. The sintered body according to claim 1, wherein a relative density is 90% or more and less than 99%.

4. The sintered body according to claim 1, wherein a rate of decrease in transverse rupture strength calculated from the following formula is 40% or less: 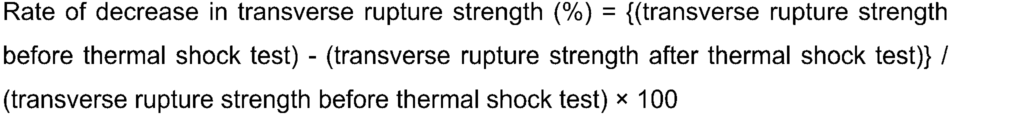 Rate of decrease in transverse rupture strength (%) = {(transverse rupture strength before thermal shock test) - (transverse rupture strength after thermal shock test)} / (transverse rupture strength before thermal shock test) × 100 provided that the thermal shock test is performed by heating the sintered body in the air under conditions of a heating rate of 5°C/min, a holding temperature of 200°C, and a holding time of 30 minutes, and then rapidly cooling the sintered body immediately after heating by allowing it to fall naturally from a height of 30 cm above a water surface into a water tank (water temperature: 20°C ± 3°C) with a depth of 30 cm.

5. The sintered body according to claim 1, wherein a volume resistivity is 10 mΩ·cm or less.

6. The sintered body according to claim 1, wherein a Zn content is 1% by mass or more and 37% by mass or less in terms of ZnO.

7. A sputtering target comprising the sintered body according to any one of claims 1 to 6.

8. A method for producing a sintered body, comprising: mixing an In₂O₃ powder and a ZnO powder to obtain a mixed powder; calcining the obtained mixed powder at 1200°C or higher and lower than 1258°C; and then pressure-sintering the calcined powder under conditions of a temperature of 1100°C or higher and 1250°C or lower and a pressing pressure of 150 kgf/cm² or more in a vacuum or an inert gas atmosphere.
